(19) Europäisches Patentamt
European Patent Office
Office européen des brevets

(11) **EP 2 944 931 B1**

(12) **EUROPÄISCHE PATENTSCHRIFT**

(45) Veröffentlichungstag und Bekanntmachung des Hinweises auf die Patenterteilung:
**14.12.2016 Patentblatt 2016/50**

(51) Int Cl.:
**G01J 3/50** (2006.01)     **H01L 33/00** (2010.01)

(21) Anmeldenummer: **15001397.7**

(22) Anmeldetag: **08.05.2015**

(54) **VERFAHREN ZUM SORTIEREN VON LICHTQUELLEN IN EINE FARBKLASSE**

METHOD FOR SORTING LIGHT SOURCES INTO A COLOUR CLASS

PROCÉDÉ DE TRI DE SOURCES LUMINEUSES DANS UNE CLASSE DE COULEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.05.2014 DE 102014007178**
**15.05.2014 DE 102014007176**

(43) Veröffentlichungstag der Anmeldung:
**18.11.2015 Patentblatt 2015/47**

(73) Patentinhaber: **Diehl Aerospace GmbH**
**88662 Überlingen (DE)**

(72) Erfinder: **Polster, Saskia**
**DE - 91054 Erlangen (DE)**

(74) Vertreter: **Diehl Patentabteilung**
**c/o Diehl Stiftung & Co. KG**
**Stephanstrasse 49**
**90478 Nürnberg (DE)**

(56) Entgegenhaltungen:
WO-A1-2012/144337     WO-A2-2014/033107
CN-A- 101 502 174     US-A1- 2010 140 633

• Yuta Asano ET AL: "Observer variability experiment using a four-primary display", Color and Imaging Conference, 21st Color and Imaging Conference Final Program and Proceedings,, 1. Januar 2013 (2013-01-01), Seiten 171-176(6), XP055207393, Gefunden im Internet: URL:http://www.cis.rit.edu/~yxa8513/Public ations/Paper_AIC2013.pdf1 [gefunden am 2015-08-12]

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Verfahren zum Sortieren von Lichtquellen in eine Farbklasse.

Lichtquellen, insbesondere Leuchtdioden, weisen fertigungsbedingt Toleranzen hinsichtlich der Lichtfarbe des von ihnen erzeugten Lichts auf. Während es prinzipiell möglich wäre, die Toleranzen in der Fertigung weiter zu vermindern, ist man jedoch dazu übergegangen, die Lichtquellen hinsichtlich der Lichtfarbe toleranzbehaftet zu produzieren und die Lichtquellen nachfolgend in Farbklassen zu sortieren. Dieser Vorgang - auch Binning genannt - wird so umgesetzt, dass die Lichtquellen in unterschiedliche Klassen, sogenannte Bins, mit Bezug auf deren Lichtfarbe einsortiert werden. Anwenderseitig können dann Lichtquellen aus einem "Bin" geordert werden, sodass auch bei einer Zusammenstellung von einer Vielzahl von Lichtquellen in einer Beleuchtungseinrichtung es zu keinen oder nur unmerklichen Toleranzen oder Variationen in der Lichtfarbe kommt.

Aus der US 2014/0028699 A1 ist ein Farbanzeigesystem bekannt, das reduzierte Beobachter-Metamerie-Fehler für eine Menge von Zielbeobachtern bietet, mit einem Bildbearbeitungssystem mit schmalbandigen Primärfarben. Ein Datenverarbeitungssystem wird verwendet, um ein Verfahren zu implementieren zur Farbkorrektur eines Eingangsfarbbildes mit Eingangsfarbwerten, die angepasst sind zur Anzeige auf einem Referenzanzeigegerät mit einer Mehrzahl von Eingangsprimärfarben. Eine Metamerie-Korrekturtransformation wird auf das Eingangsfarbbild angewendet, um ein Ausgangsfarbbild zu ermitteln, das Ausgangsfarbwerte in einem Ausgangsfarbraum aufweist, die zur Anzeige auf dem Bildbearbeitungssystem geeignet sind. Die Metamerie-Korrekturtransformation modifiziert die Farbmetrik der Eingangsfarben, um Ausgangsfarbwerte bereitzustellen, so dass ein durchschnittlicher Betrachter-Metamerie-Fehler für eine Verteilung von Zielbeobachtern reduziert ist.

Aus der US 2012/0224177 A1 sind LED-basierte Beleuchtungsmodule bekannt, die visuell farblich abgestimmt sind auf Lichtquellen, die nicht auf LEDs beruhen, basierend

Ersatz für eingereichte Beschreibungsseite 2 vom 17.11.2015:

auf optisch abgestimmten Farbräumen. Ein optisch abgestimmter Farbraum wird benutzt, um sowohl instrumentell als auch optisch eine LED-basierte Lichtquelle mit einer Lichtquelle, die nicht auf LEDs basiert, abzustimmen. In einem Aspekt wird ein LED-basiertes Beleuchtungsmodul realisiert, um einen Zielfarbpunkt in einem optisch angepassten Farbraum innerhalb einer vorbestimmten Toleranz zu erzielen. In einem weiteren Aspekt wird ein LED-basiertes Beleuchtungsmodul realisiert, um optisch mit einer Lichtquelle, die nicht auf LEDs basiert, übereinzustimmen. Ein Zielfarbpunkt im CIE 1931 XYZ-Farbraum wird abgeleitet basierend zumindest teilweise auf dem Spektrum des optisch abgestimmt LED-basierten Beleuchtungsmoduls. LED-basierte Beleuchtungsmodule, die optisch auf nicht LED-basierte Lichtquellen abgestimmt sind, werden realisiert, basierend auf dem abgeleiteten Zielfarbpunkt.

Die WO 2012/119158 A1 betrifft allgemein optische Filter, die eine Regulierung und/oder Verbesserung der Farb- und Leuchtaspekte des Farbeindrucks von Licht beim menschlichen Sehen bereitstellen, allgemein die Anwendungen solcher optischen Filter, den therapeutischen Einsatz derartiger optischer Filter, Industrie- und Sicherheitsanwendungen solcher optischer Filter, wenn diese eingebaut sind, beispielsweise in Strahlungsschutzbrillen, Verfahren zum Entwurf solcher optischer Filter, Verfahren zur Herstellung solcher optischen Filter, und Ausgestaltungen und Verfahren zum Einbringen solcher optischer Filter in Vorrichtungen einschließlich beispielsweise Brillen und Leuchtmittel.

Aus der US 2010/0140633 A1 ist es bekannt, Leuchtdioden in "Bins" mit unterschiedlich feiner Unterteilung zu sortieren und ein Farbgebiet zu definieren, das den Bin wenigstens enthält. Aus Untergebieten dieses Farbgebiets werden dann LEDs gewählt, um in einem LED-Paket kombiniert zu werden.

Aus der WO 2012/144337 A1 ist es bekannt, eine Mehrzahl lichtemittierender Elemente in eine Mehrzahl von Klassen nach Bereichen eines Kennwert zu klassifizieren. N Klassen werden ausgewählt. M lichtemittierenden Elemente werden in einem konstanten Verhältnis diesen N Klassen entnommen, um eine Licht emittierende Element-Gruppe zu bilden. Diese Element Gruppe ist so gewählt, dass ein durchschnittlicher Wert des Kennwertes der Gruppe möglichst nahe an einem Sollwert des Kennwertes für eine Lichtquelle ist. Die lichtemittierenden Elemente der Gruppen werden in der Lichtquelle periodisch angeordnet.

Aus der WO 2008/020913 A2 ist eine Leuchtstoffzusammensetzung bekannt, die in der Lage ist, die Chromatizität der Emission auf im wesentlichen konstante Werte zu regeln, auch mit Schwankungen in der Anregungsstrahlung, die sie erhalten, um Photolumineszenz induzieren.

Der Erfindung liegt die Aufgabe zugrunde, ein verbessertes Verfahren zum Sortieren von Lichtquellen vorzuschlagen.

Diese Aufgabe wird durch ein Verfahren mit den Merkmalen des Anspruchs 1 gelöst. Bevorzugte oder vorteilhafte Ausführungsformen der Erfindung ergeben sich aus den Unteransprüchen, der nachfolgenden Beschreibung sowie den beigefügten Figuren.

Die Erfindung betrifft somit ein Verfahren zum Sortieren von Lichtquellen, insbesondere Leuchtdioden, in eine Farbklasse. Unter den Lichtquellen oder Leuchtdioden (auch als "Testlichtquellen" bezeichnet, da diese hinsichtlich ihrer Lichtfarbe zu sortieren, also zu "testen" sind) wird eine Mehrzahl von Lichtquellen bzw. Leuchtdioden verstanden, welche vorzugsweise baugleich ausgebildet sind und/oder welche sortiert werden sollen. Bei alternativen Ausführungsformen der Erfindung können jedoch auch baulich unterschiedliche Lichtquellen verwendet werden. Die Farbklasse definiert bevorzugt einen "Bin". Insbesondere können mehrere Farbklassen, insbesondere Bins, vorgesehen sein, wobei die Lichtquellen in die Farbklassen verteilt werden. Die Farbklassen unterscheiden sich voneinander vorzugsweise durch die zugrunde liegenden Farbörter, wie nachfolgend dargestellt wird.

In dem Verfahren wird in einem ersten Schritt aus einer Grundmenge der Lichtquellen, also aus einer gewissen Anzahl der Testlichtquellen, eine Grobauswahlmenge in eine Zwischenklasse sortiert. Ein anderer Teil der Grundmenge wird z.B. in andere Zwischenklassen sortiert oder vollständig aussortiert. Insbesondere alle Lichtquellen in der Zwischenklasse weisen jeweils einen ersten Farbort auf, welcher in einem ersten Farbmodell innerhalb eines gemeinsamen ersten Bereichs um einen ersten Referenzfarbort angeordnet ist. Der Bereich gibt die Toleranz vor, gemäß der die Farbörter einzelner Lichtquellen dabei voneinander abweichen dürfen. Somit landen in der Zwischenklasse alle Lichtquellen aus der Grundmenge, welche - hinsichtlich deren ausgesendetem Licht - dem ersten Referenzfarbort (mit der o.g. Toleranz) entsprechen oder deren Abstand, insbesondere deren Farbortabstand, zu dem ersten Referenzfarbort unterhalb eines vorgebbaren Grenzwerts und/oder Toleranzwerts liegt. Der erste Referenzfarbort und die ersten Farbörter der Lichtquellen werden in einem ersten Farbmodell unter Verwendung eines ersten Satzes von Spektralwertfunktionen festgelegt.

In einem nachfolgenden zweiten Schritt wird aus der Grobauswahlmenge der Lichtquellen in der Zwischenklasse eine Feinauswahlmenge in die vorzugsweise finale Farbklasse sortiert. Somit wird ausgehend von allen Lichtquellen in der Zwischenklasse eine Teilmenge in die Farbklasse übernommen. Die verbleibenden Lichtquellen aus der Grobauswahlmenge werden z.B. in eine andere Farbklasse sortiert oder aussortiert. Die Lichtquellen in der Farbklasse weisen jeweils einen zweiten Farbort auf, welcher in einem zweiten Farbmodell in einem gemeinsamen zweiten Bereich um einen zweiten Referenzfarbort angeordnet ist. Der zweite Bereich definiert im obigen Sinne einen entsprechenden Toleranzbereich. Somit landen in der Farbklasse alle Lichtquellen aus der Zwischenklasse, welche dem zweiten Referenzfarbort entsprechen oder deren Abstand, insbesondere deren Farbortabstand, zu dem zweiten Referenzfarbort unterhalb eines vorgebbaren Grenzwerts und/oder Toleranzwerts liegt. Der zweite Referenzfarbort und die zweiten Farbörter sind im zweiten Farbmodell mit einem zweiten Satz von Spektralwertfunktionen festgelegt.

Der erste und der zweite Satz von Spektralwerfunktionen sind unterschiedlich ausgebildet.

Ein einfaches Sortierverfahren gemäß der Erfindung läuft damit zusammenfassend folgendermaßen ab. Aus einer Grundmenge GM an Beleuchtungsvorrichtungen wird eine Teilmenge T1 (Grobauswahlmenge GAM) aussortiert, wobei die Teilmenge T1 unter Verwendung des ersten Satzes von Spektralwertfunktionen innerhalb definierter Farbortgrenzen denselben Farbort besitzt. Aus der Teilmenge T1 wird eine weitere Teilmenge (Feinauswahlmenge FAM) aussortiert, die unter Verwendung des zweiten Satzes von Spektralwertfunktionen innerhalb definierter Farbortgrenzen denselben Farbort besitzt. Eine beliebige Anzahl weiterer Wiederholungen der vorhergehenden Art ist möglich. Als Resultat besitzen nach N Sortierschritten alle Beleuchtungsvorrichtungen der schlussendlich sich ergebenden Teilmenge TN unter Verwendung der N unterschiedlichen Spektralwertfunktionen innerhalb der entsprechenden N Farbräume jeweils den gleichen Farbort.

Die grundlegende Idee der Erfindung besteht darin, Lichtquellen so zu selektieren, dass diese unabhängig von Beobachter oder den Beobachtungsbedingungen denselben Farbeindruck hervorrufen. Dies lässt sich sowohl auf die Selektion von Lichtquellen und Beleuchtungsvorrichtungen anwenden, die in einem Beleuchtungssystem verwendet werden sollen, als auch auf RGB- oder RGBW-Lichtquellensysteme.

Der Erfindung liegt die Überlegung zugrunde, dass es bekannt bzw. in der Praxis üblich ist, ein Binning von Beleuchtungsvorrichtungen durch Verwendung der Spektralwertfunktionen der CIE von 1931 für ein Zwei-Grad-Beobachterfeld durchzuführen. Zwar konnten mit den bisherigen Binning-Verfahren metamere Gruppen von Lichtquellen gebildet werden, wobei die metameren Lichtquellen in einer Gruppe bei einem Beobachter die gleiche Farbvalenz oder die gleiche Farbwahrnehmung hervorrufen. Allerdings trifft dieser metamere Zustand der Lichtquellen nur unter den Sortierbedingungen bei dem Binning-Verfahren zu. Diese Sortierbedingungen sind nur durch einen einzigen Satz von Spektralwertfunktionen definiert. Ändert man die Randbedingungen zum Betrieb bzw. zur Beobachtung der Lichtquellen, so kann sich auch die Farbvalenz oder die Farbwahrnehmung ändern. Insbesondere wurde festgestellt, dass sich die Farbwahrnehmung abhängig von Beobachtergrößen ändert. Diese sind insbesondere die Beobachterfeldgröße und das Beobachteralter, anzunehmenderweise auch die ethnischen Zugehörigkeit des Beobachters und das Geschlecht des Beobachters, ändert. Bei Änderung dieser Beobachtergrößen ändert sich der Farbreiz der vom Licht der Lichtquellen wahrgenommen wird. Jeder veränderten Beobachtergröße ist dabei auch ein veränderter Satz von Spektralwertfunktionen zugeordnet.

Die Erfindung beruht weiterhin auf folgenden Überlegungen: Spektralwertfunktionen zur Modellierung der Zapfenempfindlichkeit im menschlichen Auge dienen der mathematischen Beschreibung des Farbeindrucks desjenigen Menschen, der vom Licht einer Lichtquelle des bestimmten Spektrums hervorgerufen wird. Da sich die spektrale Empfindlichkeit der Zapfen und die daran anschließende Signalverarbeitung von Mensch zu Mensch unterscheidet, hat jeder Mensch individuelle Spektralwertfunktionen. Um einen allgemeinen Ansatz für die Ermittlung von Farbörtern zu schaffen, werden mittlere Spektralwertfunktionen angenommen, wie beispielsweise zwei Grad und zehn Grad Normalspektralwertfunktionen der CIE. Zu den individuellen Streuungen zwischen Individuen kommen systematische Variationen hinzu. Bereits nachgewiesen wurde die systematische Abhängigkeit vom Alter und von der Beobachterfeldgröße. Zudem wird vermutet, dass eine Abhängigkeit von der ethnischen Zugehörigkeit und vom Geschlecht des Beobachters besteht.

In größeren Beleuchtungssystemen werden in der Regel Lichtquellen mit mehr oder weniger differierenden Spektren miteinander eingesetzt. Die verwendeten Lichtquellen beziehungsweise Beleuchtungsvorrichtungen werden mittels Spektralwertfunktionen so selektiert, dass sie denselben Farbort und dieselbe Helligkeit besitzen. Ein Satz Spektralwertfunktionen ist allerdings immer nur für einen definierten Beobachter und der genau bestimmten Beobachterbedingungen gültig. Das bedeutet, dass ein Satz Spektralwertfunktionen beispielsweise immer nur für einen mittleren Beobachter für ein definiertes Alter unter definierten Beobachtungsbedingungen Gültigkeit besitzt. Sollen die Lichtquellen nun aber für alle Beobachter unter allen Beobachterbedingungen gleich aussehen, so muss sichergestellt werden, dass die Lichtquellen unter Verwendung unterschiedlicher Spektralwertfunktionen in den resultierenden Farbräumen immer denselben Farbort und dieselbe Helligkeit besitzen. Um dies zu erreichen, kann man die Lichtquellen oder Beleuchtungsvorrichtungen in einem mehrstufigen Verfahren mit Hilfe mehrerer unterschiedlicher Sätze Spektralwertfunktionen sortieren. Damit erhält man Lichtquellen, die für die Mehrheit der Beobachter unter den unterschiedlichsten Beobachtungsbedingungen denselben Farbeindruck hervorrufen.

Die Erfindung beruht auch auf der Erkenntnis, dass bei dem bekannten Sortierverfahren von Lichtquellen immer nur ein einziger Satz von Spektralwertfunktionen verwendet wird. Dadurch können bei Flächenbeleuchtungen (enthaltend mehrere Lichtquellen mit unterschiedlichen Spektren) bei einem Wechsel der Beobachtungsbedingungen, welche mit einem Wechsel der Spektralwertfunktionen einhergehen, nach wie vor deutliche Farbflecken auftreten. Mit dem erfindungsgemäßen Verfahren können die Lichtquellen so sortiert werden, dass ein Wechsel des Beobachters oder der Beobachterbedingungen die Metamerie der Lichtquellen in Bezug auf die berücksichtigten Spektralwertfunktionen nicht beeinflusst.

Unter der Beobachterfeldgröße wird insbesondere ein Sichtwinkel eines Beobachters auf einem Flächenbereich der Lichtquellen verstanden. Die Beobachterfeldgröße, insbesondere der Sichtwinkel, unter der derselbe Flächenbereich wahrgenommen wird, kann sich zum einen aufgrund des Abstands zwischen dem Beobachter und der Lichtquelle ändern. So wird die Beobachterfeldgröße beziehungsweise der Sichtwinkel größer, wenn der Beobachter näher an die Lichtquellen herankommt, und kleiner, wenn sich der Beobachter von den Lichtquellen entfernt. Ferner kann sich die Beobachterfeldgröße und/oder der Sichtwinkel durch Änderung des Blickwinkels bei gleichem Abstand verändern. So ergibt sich bei einer frontalen Draufsicht, also einem Blickwinkel von 90 Grad, des Beobachters auf die Lichtquellen ein erster Sichtwinkel als Beobachterfeldgröße und bei einer schrägen Draufsicht, zum Beispiel unter einem Winkel von 10 Grad, ein schmaler Sichtwinkel und damit eine andere Beobachterfeldgröße. Der Sichtwinkel und/oder die Beobachterfeldgröße kann sich auch durch eine Kombination von Abstand und Blickwinkel ändern.

Die individuelle Farbwahrnehmung durch einen Beobachter wird durch einen speziellen Satz von Spektralwertfunktionen charakterisiert bzw. beschrieben. Diese bilden das physikalisch vorhandene bzw. messbare Spektrum der Lichtquelle auf einen subjektiv vom Beobachter wahrgenommenen Farbort - einschließlich einer entsprechend wahrgenommen Helligkeit - ab.

Während konventionelle Binning-Verfahren nur auf einen einzigen Satz von Spektralwertfunktionen abstellen, wird erfindungsgemäß vorgeschlagen, das Verfahren so zu gestalten, dass mindestens oder genau zwei unterschiedliche Sätze von Spektralwertfunktionen herangezogen werden und nur diejenigen Testleuchtdioden in die selbe Farbklasse sortiert werden, welche sowohl bei dem ersten Satz als auch bei dem zweiten Satz ausreichend nahe zu einem jeweiligen - gemeinsamen - ersten bzw. zweiten Referenzfarbort in Bezug auf deren jeweiliges Farbmodell angeordnet sind. Durch das Sortierverfahren wird erreicht, dass Lichtquellen, die beispielsweise in einer gemeinsamen Beleuchtungsvorrichtung eingesetzt werden, nicht nur bei einem ersten, durch den ersten Satz charakterisierten Beobachter, z.B. bei der Betrachtung aus einem geringen Abstand, homogen hinsichtlich der Lichtfarbe wirken, sondern auch bei einem zweiten, durch den zweiten Satz charakterisierten Beobachter, z.B. bei größerem Abstand, den gleichen Farbeindruck liefern. Somit wird erreicht, dass Lichtquellen in die Farbklasse einsortiert werden, welche hinsichtlich mindestens zweier Sätze von Spektralwertfunktionen metamer ausgebildet sind.

Bei einer bevorzugten Ausgestaltung der Erfindung sind die Lichtquellen als Leuchtdioden, insbesondere als einfarbige Leuchtdioden, insbesondere als LEDs oder als OLEDs, ausgebildet. Gerade bei der Sortierung von einfarbigen Leuchtdioden erscheint es vorteilhaft, das mindestens zweistufige Sortierverfahren einzusetzen, um farbhomogene Gruppen von Leuchtdioden zur Verwendung in gemeinsamen Beleuchtungsvorrichtungen zu erhalten.

Bei einer bevorzugten Ausgestaltung der Erfindung unterscheiden sich der erste und der zweite - oder auch weitere, siehe unten - Sätze von Spektralwertfunktionen paarweise hinsichtlich einer Beobachtergröße, insbesondere Beobachterfeldgröße und/oder einem Beobachteralter und/oder einem Beobachtergeschlecht und/oder einer ethnischen Beobachterzugehörigkeit. Insbesondere ist die erste Beobachterfeldgröße als ein 2-Grad-Beobachterfeld und/oder die zweite Beobachterfeldgröße als ein 10-Grad-Beobachterfeld ausgebildet. Diese gewählten Beobachterfeldgrößen haben sich mittlerweile als Normbeobachter etabliert, sodass zum einen auf analytische Formeln für diese Beobachterfeldgrößen und zum anderen auf umfangreiches Mess- und damit Vergleichsmaterial zurückgegriffen werden kann. Physikalisch betrachtet werden durch die beiden stark unterschiedlichen Beobachterfeldgrößen unterschiedliche Bereiche des menschlichen Auges berücksichtigt, welche zu den größten Farbortänderungen beim Wechsel der Beobachterfeldgröße führen, sodass das Verfahren mit den vorgeschlagenen Beobachterfeldgrößen besonders aussagekräftig ist.

Bei einer bevorzugten Realisierung der Erfindung ist das erste und/oder das zweite Farbmodell als ein CIE-Lu'v'-Farbraumsystem ausgebildet, wobei die Farbörter mit den Koordinaten u'- und v'- dargestellt werden. Der Vorteil dieser Farbmodelle ist, dass der geometrische Abstand der Farbörter annähernd dem empfindungsgemäßen Abstand der Farben der Farbörter beschreibt. Die Wahl dieser Farbmodelle hat somit den Vorteil, dass die Größe der Bereiche der Farbörter unmittelbar eine Aussagekraft haben. Es ist nämlich unmittelbar verständlich, dass je kleiner der Bereich um einen Farbort ist, desto geringer die Streuungen oder Toleranzen hinsichtlich der wahrgenommenen Farbe ausfallen.

Bei einer bevorzugten Ausgestaltung der Erfindung wird der erste und/oder der zweite Farbort durch eine virtuelle oder reale Referenzlichtquelle, insbesondere Referenzleuchtdiode, definiert. Somit kann zum einen eine physikalisch existierende Referenzlichtquelle verwendet werden, um den ersten und/oder den zweiten Referenzfarbort zu definieren. Alternativ hierzu kann ein dementsprechender erster und/oder zweiter Referenzfarbort auch nur rechnergestützt oder virtuell erstellt werden.

Die Lichtquellen in der Zwischenklasse sind besonders bevorzugt metamer zu der Referenzlichtquelle beziehungsweise zu dem entsprechenden virtuell erstellten Referenzfarbort in dem ersten Farbmodell mit dem ersten Satz von Spektralwertfunktionen ausgebildet. Der zweite Bereich wird dagegen bevorzugt durch einen Metamerie-Index für Beobachterabhängigkeit (MiB) zwischen den zu testenden Lichtquellen und der Referenzlichtquelle festgelegt. Hier ist nur maximal ein bestimmter Wert des Metamerieindex erlaubt. Durch den Metamerie-Index für Beobachterabhängigkeit (MIB) wird insbesondere ein Maß definiert, wie gut zwei unterschiedliche Lichtquellen in der Lage sind, denselben Farbeindruck, dieselbe Farbvalenz und/oder das gleiche Farbempfinden zu liefern, obwohl sich die Beobachter hinsichtlich des Satzes der zugeordneten Spektralwertfunktionen, insbesondere hinsichtlich Beobachterfeldgröße, insbesondere der Sichtwinkel, auf einen definierten Flächenbereich der Leuchtdioden ändern. Für einen Metamerieindex von Null sind die wahrgenommenen Farbeindrücke gleich.

Bei einer möglichen Ausgestaltung der Erfindung werden die Farbörter der Lichtquellen und/oder - falls vorhanden bzw. im Verfahren verwendet - der Metamerie-Index für Beobachterabhängigkeit (MIB) experimentell, insbesondere messtechnisch unterstützt, erfasst. Beispielsweise kann durch den Einsatz eines Farbsensors der Farbort der Testlichtquellen und/oder der Referenzlichtquelle in dem ersten Farbmodell bestimmt werden und mit dem ersten Referenzfarbort verglichen werden. In Weiterbildung kann mit einem oder dem Farbsensor der Farbort der Testlichtquellen und/oder der Referenzlichtquelle in dem zweiten Farbmodell mit dem zweiten Satz von Spektralwertfunktionen bestimmt werden und mit dem zweiten Referenzfarbort verglichen werden. In Abhängigkeit von einer Definition von möglichen Abweichungen des gemessenen Farborts von dem ersten beziehungsweise zweiten Referenzfarbort in einem erlaubten Bereich kann eine Sortierung umgesetzt werden.

Bei einer anderen Ausgestaltung der Erfindung wird in einem ersten Referenzschritt aus dem Emissionsspektrum der Referenzlichtquelle über einen ersten Spektralwertfunktionensatz für das erste Farbmodell der erste Referenzfarbort in dem ersten Farbmodell ermittelt.

Ein derartiger Spektralwertfunktionensatz, insbesondere für eine 2-Grad-Beobachterfeldgröße, ist zum Beispiel in der folgenden Quelle offenbart:

CIE 1931: Colorimétrie, Resolutions 1-4. In: Recueil des travaux et compte rendu des séances, Hutieme Session Cambridge, The National Physical Laboratory Teddington, Cambridge at the University Press, 1931, S. 19-29.

Ein ähnlicher Spektralwertfunktionensatz kann auch aus der Empfehlung CIE 170-1:2006 der CIE abgeleitet werden.

Alternativ wird in dem ersten Referenzschritt der erste Referenzfarbort definiert.

In einem ersten Zwischenschritt wird aus dem jeweiligen Emissionsspektrum der Testlichtquellen über den ersten Spektralwertfunktionensatz für das erste Farbmodell für die Testlichtquellen deren jeweiliger erster Farbort in dem ersten Farbmodell ermittelt.

Der Test, ob die Farbörter in dem Bereich des ersten Referenzfarborts (im erlaubten Bereich um den Referenzfarbort) liegen, gemäß dem zuerst genannten Schritt kann durch einen Vergleich der gemessenen Farbörter mit dem gemessenen oder definierten ersten Referenzfarbort durchgeführt werden. Z.B. kann der Bereich durch einen Farbortabstand in dem ersten Farbmodell definiert sein. Somit werden in die Zwischenklasse ausschließlich die Testlichtquellen einsortiert, die mit ihrem Farbort innerhalb des Bereichs des ersten Referenzfarborts liegen und im Sinne dieser Definition metamer zu der Referenzlichtquelle sind.

In einem zweiten Referenzschritt wird aus dem Emissionsspektrum der Referenzlichtquelle über den zweiten Spektralwertfunktionensatz für das zweite Farbmodell der zweite Referenzfarbort in dem zweiten Farbmodell ermittelt.

Eine derartige Spektralwertfunktion, insbesondere für eine 10-Grad-Beobachterfeldgröße, ist zum Beispiel in der folgenden Quelle offenbart:

CIE 1964: Offizielle Empfehlungen, Komitee E-1.3.1. - Farbmessung. In: 15. Hauptversammlung in Wien, CIE Publication 11A, 1963, S. 37.

Ein ähnlicher Spektralwertfunktionensatz kann auch aus der Empfehlung CIE 170-1:2006 der CIE abgeleitet werden.

Alternativ wird in dem zweiten Referenzschritt der zweite Referenzfarbort definiert.

In einem zweiten Zwischenschritt wird aus dem jeweiligen Emissionsspektrum der Testlichtquellen aus der Zwischenklasse über den zweiten Spektralwertfunktionensatz für das zweite Farbmodell für die Testlichtquellen der jeweilige zweite Farbort in dem zweiten Farbmodell ermittelt.

Der Test, ob die zweiten Farbörter in dem Bereich des zweiten Referenzfarborts liegen, gemäß dem nachfolgenden Schritt kann durch einen Vergleich der gemessenen zweiten Farbörter mit dem gemessenen oder definierten zweiten Referenzfarbort durchgeführt werden. Z.B. kann hierzu der Abstand zwischen dem zweiten Referenzfarbort und den zweiten Farbörtern der Testlichtquellen in dem zweiten Farbmodell für jede Testlichtquelle als Farbortabstand definiert werden. Für den Fall, dass in dem ersten Schritt nur metamere Testleuchtdioden in die Zwischenklasse einsortiert wurden und dass in dem zweiten Zwischenschritt nur Testleuchtdioden aus der Zwischenklasse verwendet wurden, bildet der Farbortabstand zwischen dem in Bezug auf das zweite Farbmodell ermittelten zweiten Farbort der Testlichtquellen und dem in dem zweiten Referenzschritt ermittelten oder vorab definierten zweiten Referenzfarbort für das zweite Farbmodell den Metamerie-Index für Beobachterabhängigkeit (MiB).

Das in den Ansprüchen beschriebene Verfahren kann in der dargestellten Reihenfolge durchgeführt werden, es ist jedoch auch möglich, dass Verfahrensschritte in der zeitlichen Reihenfolge umgestellt oder zusammengefasst werden. Insbesondere ist es möglich, dass zunächst sämtliche Referenzschritte durchgeführt werden. Alternativ oder ergänzend ist es möglich, dass die Zwischenschritte auf alle Testlichtquellen angewendet wird und die Sortierung erst nachträglich erfolgt.

Bei einer alternativen Ausgestaltung der Erfindung werden in dem ersten Schritt zunächst in die Zwischenklasse metamere Testlichtquellen einsortiert. Zur Bestimmung des Metamerie-Indexes für Beobachterabhängigkeit (MiB) wird für jede der Testlichtquellen in der Zwischenklasse ein Differenzspektrum zwischen dem eigenen Emissionsspektrum und dem Emissionsspektrum der Referenzlichtquelle ermittelt und über einen spektralen Änderungsempfindlichkeitsfunktionensatz bewertet, wobei der spektrale Änderungsempfindlichkeitsfunktionensatz ein Maß definiert, wie die Unterschiede zwischen den Emissionsspektren in dem Differenzspektrum zu dem Metamerie-Index beitragen.

Der Änderungsempfindlichkeitsfunktionensatz kann wie folgt erstellt werden: Der Grundgedanke ist es, zu untersuchen, wie sich Änderung in den Spektralwerten X, Y, Z auf die u'- Komponente bzw. v' - Komponente in dem zweiten Farbmodell auswirken. Mathematisch ausgedrückt ist dies die folgende partielle Ableitung:

$$\Delta u' = \frac{\partial u'}{\partial X} \cdot \Delta X + \frac{\partial u'}{\partial Y} \Delta Y + \frac{\partial u'}{\partial Z} \cdot \Delta Z$$

mit:

X, Y, Z Farbwerte im zweiten Farbsystem
u' Farbkomponente in dem zweiten Farbmodell

mit:

$$u' = \frac{4X}{X + 15Y + 3Z}$$

und mit dem Ansatz:

$$\Delta X = \int_{380nm}^{780nm} \overline{x}_{zweitesFarb\,mod\,ell}(\lambda) \cdot S2(\lambda)d\lambda - \int_{380nm}^{780nm} \overline{x}_{zweitesFarb\,mod\,ell}(\lambda) \cdot S1(\lambda)d\lambda$$

$$= \int_{380nm}^{780nm} \overline{x}_{zweitesFarb\,mod\,ell}(\lambda) \cdot S_{diff}(\lambda)d\lambda$$

Somit ergibt sich aus der oben-genannten partiellen Ableitung:

$$\Delta u' = \int_{380nm}^{780nm} \frac{1}{(X+15Y+3Z)^2} \cdot$$

$$[(60Y+12Z)\cdot \overline{x}_{zweitesFarb\,mod\,ell}(\lambda)+(-60X)\cdot \overline{y}_{zweitesFarb\,mod\,ell}(\lambda))+(-12X)\cdot \overline{z}_{zweitesFarb\,mod\,ell}(\lambda)]\cdot$$

$$S_{diff}(\lambda)d\lambda$$

Somit ergibt sich die Änderungsempfindlichkeitsfunktion für die u' - Komponente zu:

$$\Delta u'_{empf}(\lambda) = \frac{1}{(X+15Y+3Z)^2} \cdot$$

$$[(60Y+12Z)\cdot \overline{x}_{zweitesFarb\,mod\,ell}(\lambda)+(-60X)\cdot \overline{y}_{zweitesFarb\,mod\,ell}(\lambda))+(-12X)\cdot \overline{z}_{zweitesFarb\,mod\,ell}(\lambda)]$$

Die Änderungsempfindlichkeitsfunktion für die v' - Komponente kann analog berechnet werden, wobei beide Änderungsempfindlichkeitsfunktionen den Änderungsempfindlichkeitsfunktionensatz bilden.
Ausgehend von dem Änderungsempfindlichkeitsfunktionensatz und dem Differenzspektrum kann der Farbort-Abstand und damit der Metamerie-Index wie folgt bestimmt werden:

$$\Delta u'_{MIB(Farb\,mod\,ell1|Farb\,mod\,ell2)} = \int \Delta u'_{empf} \cdot S_{diff}(\lambda)d\lambda$$

$$\Delta v'_{MIB(Farb\,mod\,ell1|Farb\,mod\,ell2)} = \int \Delta v'_{empf} \cdot S_{diff}(\lambda)d\lambda$$

$$\Delta u'v'_{MIB(Farb\,mod\,ell1|Farb\,mod\,ell2)} = \sqrt{\Delta u'^2 + \Delta v'^2}$$

mit:

$S_{diff}(\lambda)$ Differenzspektrum

$\Delta u'_{empf}$ Änderungsempfindlichkeitsfunktion für die u'-Komponente

$\Delta v'_{empf}$ Änderungsempfindlichkeitsfunktion für die v'-Komponente

$\Delta u'_{MB(Farbmodell1|Farbmodell2)}$ u'-Komponente des Farbortabstands in dem zweiten Farbmodell

$\Delta v'_{MIB(Farbmodell1|Farbmodell2)}$ v'-Komponente des Farbortabstands in dem zweiten Farbmodell

$Du'v'_{MIB(Farbmodell1|Farbmodell2)}$ Farbortabstand in dem zweiten Farbmodell / Metamerie-Index für Beobachterfeldgrößenabhängigkeit (MIB)

Gemäß einer bevorzugten Ausführungsform wird ein mindestens dreistufiges Sortierverfahren von Lichtquellen vorgeschlagen. Demgemäß können nämlich weitere Sortierstufen, insbesondere mindestens eine dritte, allgemein weitere bzw. n-te Sortierstufe, dem zweistufigen Verfahren zum Beispiel vorgeschaltet, zwischengeschaltet und/oder nachgeschaltet werden, welche eine Vorauswahl, Zwischenauswahl oder Nachauswahl der Lichtquellen umfasst. In der mindestens einen dritten oder weiteren, n-ten Sortierstufe werden die Lichtquellen ausgewählt, welche in einem gemeinsamen dritten oder weiteren, n-ten Bereich um einen dritten oder weiteren, n-ten Referenzfarbort angeordnet sind, wobei der dritte oder weitere, n-te Referenzfarbort in einem dritten oder weiteren, n-ten Farbmodell mit einem dritten oder weiteren, n-ten Satz von Spektralwertfunktionen festgelegt ist.

Das Verfahren kann also zum ersten und zweiten Schritt mindestens einen oder mehrere weitere n-te Schritte aufweisen, wobei z.B. in einem jeweils nachfolgenden Schritt aus der bis dahin bestehenden (Fein-)Auswahlmenge der Lichtquellen eine weitere Feinauswahlmenge n-ter Ordnung in eine Farbklasse n-ter Ordnung sortiert wird, wobei die Farbörter der Lichtquellen der Farbklasse n-ter Ordnung in einem gemeinsamen Bereich um den n-ten Referenzfarbort angeordnet sind, wobei der n-te Referenzfarbort in einem n-ten Farbmodell mit einem n-ten Satz von Spektralwertfunktionen festgelegt ist, wobei der erste, zweite und alle n-ten Sätze von Spektralwertfunktionen unterschiedlich ausgebildet sind. Statt einem nachgeschalteten weiteren Schritt kann auch ein vorgeschalteter Schritt zur Vorsortierung oder ein zwischengeschalteter Schritt zur Zwischensortierung in gleicher Weise vorgesehen sein.

Sämtliche Sätze von Spektralwertfunktionen sind dabei jeweils paarweise verschieden ausgebildet.

Gemäß der Erfindung und ihren bevorzugten Ausführungsformen ergibt sich also zusammenfassend ein Verfahren zum zweistufigen, insbesondere mehrstufigen Sortieren von Lichtquellen. Als Lichtquellen kommen sämtliche Beleuchtungsvorrichtungen oder Leuchtmittel mit variierenden Spektren in Frage. Die Sortierung erfolgt in Bezug auf beliebige Beobachtergrößen bzw. Kriterien, welche sich mittels Spektralwertfunktionen beschreiben lassen. Solche sind insbesondere Beobachterfeldgröße, Beobachteralter, vermutlich auch ethnische Zugehörigkeit und Geschlecht des Beobachters. Betrachtet werden also sowohl individuelle Streuungen zwischen Individuen als Beobachtern als auch systematische Variationen zwischen verschiedenen Beobachtertypen. Im Ergebnis führt die Erfindung zu einer homogenen Flächenbeleuchtung unter Verwendung beliebiger Lichtquellen aus der Farbklasse, obwohl diese variierende Spektren aufweisen. Die Homogenität gilt allgemein für alle Personen und unter allen Beobachtungssituationen, welche durch die dem Verfahren zugrunde gelegten Sätze von Spektralwertfunktionen berücksichtigt sind. Für all diese Personen und Beobachtungssituationen ergibt sich dann derselbe Farbeindruck für alle Lichtquellen der Farbklasse.

Im Ergebnis können unterschiedliche Lichtquellen in einem zwei- bis mehrstufigen Verfahren so sortiert werden, dass sie unter unterschiedlichen Bedingungen, welche sich mittels Spektralwertfunktionen beschreiben lassen, immer denselben Farbeindruck liefern. Die unterschiedlichen Bedingungen sind insbesondere unterschiedliches Betrachteralter, unterschiedliche Beobachterfeldgröße sowie natürliche Variationen unter Menschen.

Gemäß dem Verfahren ergibt sich also eine Unabhängigkeit der Metamerie von Lichtquellen vom Beobachter und von den Beobachtungsbedingungen. Es ergibt sich ein Verfahren zur Ermittlung beziehungsweise zum Auffinden von Lichtquellen, die eine hohe Kompatibilität für die gemeinsame Verwendung in einer farblich homogegen Flächenbeleuchtung aufweisen, die unabhängig von Beobachtungsbedingungen ist.

Durch das Verfahren können insbesondere weiße LEDs für die Verwendung in weißen Standardleuchten für eine Flugzeuginnenraumbeleuchtung selektiert werden.

In dem Verfahren kann auch eine Verwendung von Metamerie-Indizes stattfinden. Mit Hilfe von Metamerie-Indizes kann eine Aussage darüber getroffen werden, wie gut zwei unterschiedliche Lichtquellen geeignet sind, unabhängig von einem vorgegebenen Kriterium, welches mit Hilfe von Spektralwertfunktionen beschrieben werden kann, denselben Farbeindruck zu liefern. Je kleiner der Indexwert ist, desto geringer sind die Auswirkungen eines Wechsels des Kriteriums, insb. der Beobachtergröße, auf die wahrgenommene Farbdifferenz zwischen den beiden Lichtquellen. Metamerie-Indizes lassen sich beispielsweise für einen Wechsel des Beobachterfeldes von zwei Grad auf zehn Grad, aber auch für Altersabhängigkeit, individuelle Unterschiede von Beobachtern und so weiter bestimmen.

Weitere Merkmale, Vorteile und Wirkungen der Erfindung ergeben sich aus der nachfolgenden Beschreibung eines bevorzugten Ausführungsbeispiels der Erfindung sowie der beigefügten Figuren. Dabei zeigen:

Figur 1a    ein Beleuchtungssystem bestehend aus oder umfassend zwei Leuchtdioden mit zwei zugehörigen Emissionsspektren ;

Figur 1b    eine schematische Darstellung zur Erläuterung der Änderung der Beobachterfeldgröße bei Änderung eines Beobachtungsabstands;

Figur 1c    eine schematische Darstellung zur Beschreibung der Änderung der Beobachterfeldgröße bei Änderung eines Blickwinkels;

Figur 2    ein Flussdiagramm zur Illustration eines Ausführungsbeispiels der Erfindung;

Figur 3          ein weiteres Flussdiagramm zur Illustration eines weiteren Ausführungsbeispiels der Erfindung.

Figur 4          ein Beleuchtungssystem bestehend aus oder umfassend zwei Beleuchtungsvorrichtungen mit zwei zugehörigen Grundspektrensätzen;

Figur 5          ein Diagramm zur Erläuterung einer weiteren möglichen Ausgestaltung der Erfindung;

Figur 6          ein Diagramm zur Erläuterung einer weiteren möglichen Ausgestaltung der Erfindung.

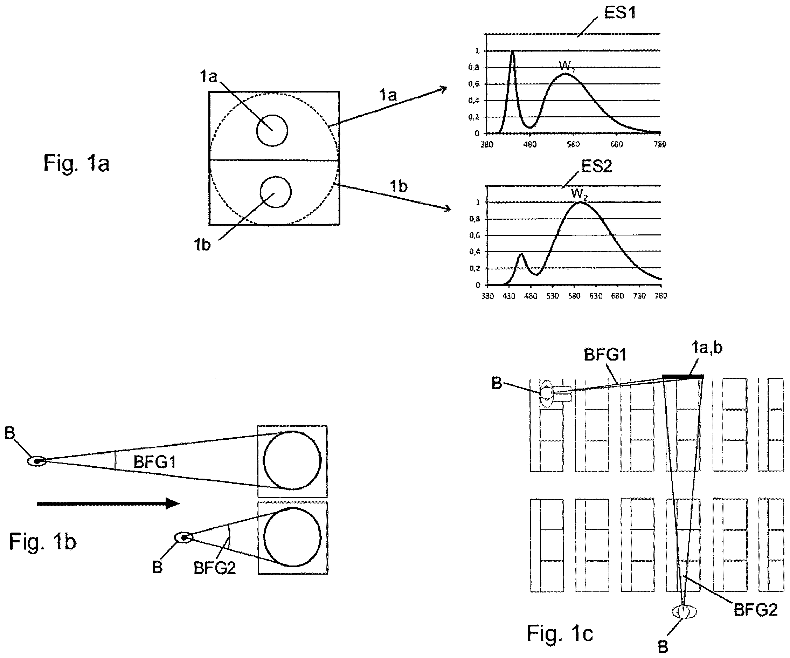

Die Figur 1 a zeigt in einer stark schematisierten Darstellung eine erste und eine zweite Lichtquelle 1 a, b, in Form von Leuchtdioden, die gemeinsam ggf. mit weiteren Leuchtdioden ein Flächenbeleuchtungssystem als eine Beleuchtungsvorrichtung bilden. Das Flächenbeleuchtungssystem wird beispielsweise als Flugzeugbeleuchtungen für den Innenraum verwendet.

Rechts daneben sind für die erste Lichtquelle 1 a und für die zweite Lichtquelle 1 b jeweils deren Emissionsspektrum ES1 beziehungsweise ES2 dargestellt. Beide Lichtquellen 1a, b sind als weiße Leuchtdioden ausgebildet, weisen jedoch unterschiedliche Emissionsspektren ES1 und ES2, hier Einzelspektren W1,2 auf. Derartige Unterschiede können bei baugleichen Leuchtdioden durch Herstellungstoleranzen kommen. Alternativ ist es möglich, dass sich die Lichtquellen 1a, b in der Bauart unterscheiden. In den Emissionsspektren ist die Intensität oder Leuchtdichte auf 1 normiert über die Wellenlänge Lambda aufgetragen.

Prinzipiell wird versucht, dass in einer Beleuchtungsvorrichtung nur Leuchtdioden verwendet werden, welche metamer zueinander ausgebildet sind, das heißt, das gleiche Farbempfinden oder die gleiche Farbvalenz bei einem Beobachter hervorrufen. Jedoch wurde festgestellt, dass sich das Farbempfinden oder die Farbvalenz unter anderem mit Änderung einer Beobachtergröße, hier der Beobachterfeldgröße bei einem Beobachter ändert. Somit können Lichtquellen 1 a, b bei einer ersten Beobachtergröße zueinander metamer ausgebildet sein, sich jedoch in der Farbvalenz oder dem Farbempfinden bei einer anderen Beobachtergröße unterscheiden. Somit gilt der metamere Zustand nur für die Bedingungen der ersten Beobachtergröße, bei anderen Beobachtergrößen verschlechtert sich die Farbähnlichkeit der Lichtquellen 1 a, b. Eine Änderung der Beobachtergröße in Form der Beobachterfeldgröße kann sich im Betrieb der Lichtquellen 1 a, b zum einen durch eine Änderung des Beobachtungsabstands ergeben, wie dies in der Figur 1 b dargestellt ist.

In der Figur 1 b ist ein Beobachter B visualisiert, welcher sich in zwei unterschiedlichen Beobachtungsabständen zu den Lichtquellen 1 a, b befindet und auf die Lichtquellen 1 a, b blickt. Bei einem größeren Abstand ergibt sich eine erste Beobachterfeldgröße BFG1, welche in diesem Beispiel einen Gesamtwinkel von 2 Grad als Sichtwinkel einnimmt. Bei einem kleineren Abstand ergibt sich eine zweite Beobachterfeldgröße BFG2, welche in diesem Beispiel einen Gesamtwinkel von 10 Grad als Sichtwinkel einnimmt. Gemäß der Figur 1c können sich unterschiedliche Beobachterfeldgrößen BFG1,2 auch durch unterschiedliche Blickwinkel ergeben. So ergibt sich in dem Beispiel in der Figur 1 c die zweite Beobachterfeldgröße BFG2, wenn der Beobachter B senkrecht, das heißt mit einem Blickwinkel von 90 Grad, auf die Lichtquelle 1 a, b blickt und die erste Beobachtungsfeldgröße BFG1, wenn der Beobachter B mit einem Blickwinkel von ca. 10 Grad auf die Lichtquelle 1 a, b blickt.

Zur Beschreibung der wahrgenommenen Farbe der Lichtquellen 1 a, b werden Farbmodelle verwendet, in denen Farbörter für die Farbe der Leuchtdioden 1 a, b eingetragen werden können. Ein typisches Farbmodell ist das Lu'v'-Farbmodell nach CIE. Es existieren jedoch mehrere derartige Farbmodelle, wobei sich die Farbmodelle bei den Rahmenbedingungen in der Beobachtergröße unterscheiden. So gehört zu der Definition eines Farborts auch die Angabe des zugrundeliegenden Farbmodells mit der Beobachtergröße und dem zugehörigen Satz von Spektralwertfunktionen.

Bei einer Änderung der Beobachtergröße, hier des Sichtwinkels und damit der Beobachterfeldgröße, wie dies in den Figuren 1 b und 1 c dargestellt war, ändert sich auch das zugrundeliegende Farbmodell.

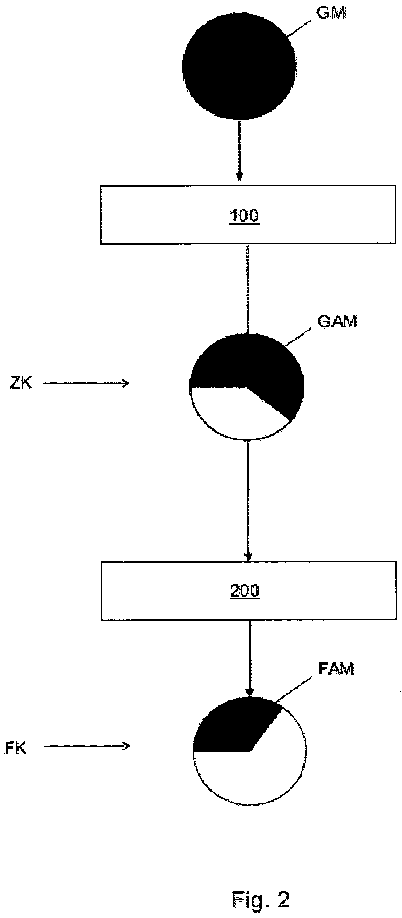

Die Figur 2 zeigt ein stark schematisiertes Ablaufdiagramm für ein Ausführungsbeispiel des erfinderischen Verfahrens für das Sortieren der Lichtquellen 1 a, b als Testleuchtdioden. Ausgehend von einer Grundmenge GM von Testleuchtdioden, welche sortiert werden sollen, werden in einem ersten Schritt 100 die ersten Farbörter der Testleuchtdioden bestimmt, und zwar in Bezug auf ein erstes Farbmodell mit einer ersten Beobachtergröße, wobei der jeweilige erste Farbort durch einen ersten Spektralwertfunktionensatz CMF1 festgelegt wird, der die Beobachtergröße wiederspiegelt. Nachfolgend werden alle Testleuchtdioden in eine Zwischenklasse ZK sortiert, deren jeweiliger erster Farbort in einem gemeinsamen ersten Bereich um einen ersten Referenzfarbort in Bezug auf das erste Farbmodell mit der ersten Beobachtergröße liegt. In dieser Zwischenklasse ZK wird somit eine Grobauswahlmenge GAM als Teilmenge der Grundmenge GM der Testleuchtdioden sortiert. Der erste Referenzfarbort, welcher in Bezug auf das erste Farbmodell mit der ersten Beobachtergröße und dem ersten Spektralwertfunktionensatz CMF1 festgelegt ist, kann beispielsweise auch vorgegeben sein.

In einem nachfolgenden Schritt 200 werden ausgehend von der Grobauswahlmenge GAM alle die Testleuchtdioden in eine Farbklasse FK sortiert, welche einen zweiten Farbort in Bezug auf ein zweites Farbmodell mit einer zweiten Beobachtergröße und einem zweiten Spektralwertfunktionensatz CMF2 aufweisen, welche in einem zweiten Bereich um einen zweiten Referenzfarbort angeordnet sind. Der zweite Referenzfarbort ist dabei in Bezug auf das zweite Farbmodell mit der zweiten Beobachtergröße und dem zweiten Spektralwertfunktionensatz CMF2 festgelegt. Die Testleuchtdioden, welche in die Farbklasse FK einsortiert sind, bilden eine Feinauswahlmenge FAM, welche eine Teilmenge der Grobauswahlmenge GAM bildet.

Somit ist ein Sortierverfahren dargestellt, welches die Testleuchtdioden zweistufig in die Farbklasse FK einordnet, wobei in jeder Stufe der Farbort der jeweiligen Testleuchtdiode in Bezug auf einen Referenzfarbort von einem ersten Farbmodell beziehungsweise zweiten Farbmodell geprüft wird.

Es ist möglich, dass die Testleuchtdioden wie beschrieben nacheinander geprüft und sortiert werden. Es ist jedoch auch möglich, dass alle Testleuchtdioden aus der Grundmenge GM hinsichtlich ihrem ersten und zweiten Farbort in dem ersten und in dem zweiten Farbmodell geprüft werden und nachfolgend die Testleuchtdioden in die Farbklasse FK sortiert werden, welche sowohl in dem ersten Bereich um den ersten Referenzfarbort im ersten Farbmodell als auch um den zweiten Bereich zu dem zweiten Referenzfarbort im zweiten Farbmodell mit ihrem jeweiligen Farbort liegen.

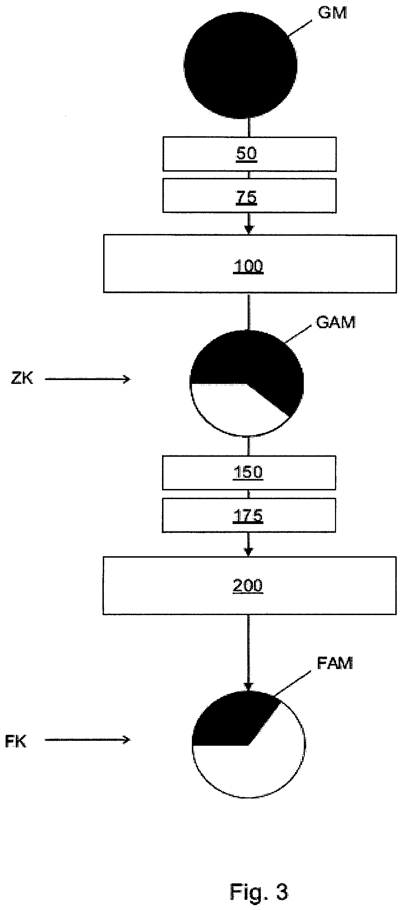

Die Figur 3 zeigt eine Variation des Verfahrens aus Figur 2, wobei in einem ersten Referenzschritt 50 mit Bezug auf eine Referenzlichtquelle, hier -leuchtdiode in dem ersten Farbmodell mit der ersten Beobachtergröße und dem ersten Spektralwertfunktionensatz deren erster Farbort als ein erster Referenzfarbort ermittelt wird.

In dem nachfolgenden ersten Zwischenschritt 75 wird aus dem Emissionsspektrum der Testleuchtdioden über den ersten Spektralwertfunktionensatz CMF1 für das erste Farbmodell mit der ersten Beobachtergröße der jeweilige erste Farbort der Testleuchtdiode in dem ersten Farbmodell ermittelt.

In dem Schritt 100 werden dann wie zuvor die Testleuchtdioden in die Grobauswahlmenge GAM sortiert, deren Farbörter innerhalb eines vorgebbaren ersten Bereichs um den ersten Referenzfarbort der Referenzleuchtdiode angeordnet ist.

In einem zweiten Referenzschritt 150 wird aus dem Emissionsspektrum der Referenzleuchtdiode über einen zweiten Spektralwertfunktionensatz CMF2 für das zweite Farbmodell mit der zweiten Beobachtergröße deren zweiter Farbort in dem zweiten Farbmodell als zweiter Referenzfarbort ermittelt.

In dem zweiten Zwischenschritt 175 werden aus den Emissionsspektren der Testleuchtdioden über den zweiten Spektralwertfunktionensatz für das zweite Farbmodell mit der zweiten Beobachtergröße die zweiten Farbörter in dem zweiten Farbmodell für die Testleuchtdioden ermittelt.

In dem Schritt 200 werden dann die Testleuchtdioden in die Farbklasse FK einsortiert, deren zweite Farbörter innerhalb des zweiten Bereichs um den zweiten Referenzfarbort für das zweite Farbmodell angeordnet sind.

Auch bei der Ausgestaltung des Verfahrens gemäß der Figur 3 können beispielsweise die Referenzschritte vorab durchgeführt werden oder sogar durch virtuelle Werte, also Soll-Werte, welche zum Beispiel nicht messtechnisch ermittelt worden sind, sondern nur vorgegeben wurden, ersetzt werden. Es ist auch möglich, dass erster und zweiter Zwischenschritt 75, 175 jeweils für alle Testleuchtdioden durchgeführt werden und nachfolgend in den Sortierschritten 100, 200 die Sortierungen erfolgen.

In einer weiteren Ausgestaltung ist es zum Beispiel möglich, dass in dem Schritt 100 alle Testleuchtdioden in die Grobauswahlmenge GAM eingegliedert werden, welche gemäß einer vorgebbaren Definition metamer zueinander sind und in dem Schritt 200 alle Testleuchtdioden in die Farbklasse FK übernommen werden, deren Metamerie-Index für Beobachterabhängigkeit (MiB) kleiner als ein vorgebbarer Wert ist.

Der Metamerie-Index für Beobachterabhängigkeit (MiB) kann zum einen durch den Abstand des Referenzfarbortes der Referenzleuchtdiode und den Farbörtern der Testleuchtdioden aus der Grobauswahlmenge GAM bestimmt werden. Alternativ hierzu kann der Metamerie-Index für Beobachterabhängigkeit (MiB) auch über einen Änderungsempfindlichkeitsfunktionensatz bestimmt werden, wie oben ausgeführt. Bei dieser Alternative wird der Änderungsempfindlichkeitsfunktionensatz in Abhängigkeit der Referenzleuchtdiode und deren zweiten Referenzfarbort in dem zweiten Farbmodell bestimmt. Das Differenzspektrum $S_{diff}(\lambda)$ ergibt sich aus dem Emissionsspektrum der Referenzleuchtdiode und dem Emissionsspektrum der Testleuchtdiode aus der Grobauswahlmenge GAM.

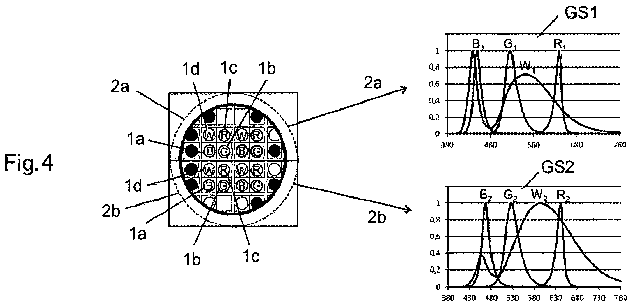

Die Figur 4 zeigt in einer stark schematisierten Darstellung eine erste und eine zweite Beleuchtungsvorrichtung 2 a, b, die gemeinsam ein Flächenbeleuchtungssystem bilden. Die Beleuchtungsvorrichtungen 2 a, b weisen jeweils eine Mehrzahl von Lichtquellen 1 a, b, c, d in Form von verschiedenfarbigen LEDs auf. Die Beleuchtungsvorrichtungen 2 a, b werden beispielsweise als Flugzeugbeleuchtungen für den Innenraum verwendet und sind z.B. als Flächenleuchten realisiert.

Rechts daneben sind für die erste Beleuchtungsvorrichtung 2a und für die zweite Beleuchtungsvorrichtung 2b jeweils die Grundspektrensätze bzw. Grundspektren GS1 beziehungsweise GS2 dargestellt, wobei in den Grundspektren GS1 beziehungsweise GS2 für jede Lichtquelle 1 a, b, c, d das Einzelspektrum dargestellt ist. In den Spektren ist die Intensität oder Leuchtdichte auf 1 normiert über die Wellenlänge Lambda aufgetragen. Beispielsweise bezeichnen die Einzelspektren B1/B2 die spektralen Verläufe von blauen LEDs als Lichtquellen 1a, die Einzelspektren G1/G2 die spektralen Verläufe der Lichtquellen 1b, welche als grüne LED ausgebildet sind, die Einzelspektren R1/R2 zeigen den spektralen Verlauf der Lichtquellen 1 c, welche als rote LEDs ausgebildet sind, und die Einzelspektren W1/W2 die spektralen Verläufe der Lichtquellen 1d, welche als weiße LEDs ausgebildet sind. Aus den beiden Gesamtspektren bzw. Grundspektren GS1 und GS2 ist zu entnehmen, dass sich die spektralen Verläufe der Beleuchtungsvorrichtungen 2a und 2b unterscheiden.

Um die Beleuchtungsvorrichtungen 2a und 2b gemeinsam einsetzen zu können, werden diese auf einen gemeinsamen Farbort in einem ersten Farbmodell eingestellt. Das erste Farbmodell wird über eine erste Beobachtergröße, in diesem Beispiel eine Beobachterfeldgröße BFG1 mit einem Winkel von 2°, und einen an die Beobachtergröße angepassten, ersten Spektralwertfunktionensatz CMF1 festgelegt. Hierzu werden die Intensitäten der Lichtquellen 1 a, b, c, d so gewählt, dass sich ein gemeinsamer Zielfarbort als erster Referenzfarbort in dem ersten Farbmodell für die erste Beobachtergröße für die zwei Beleuchtungsvorrichtungen 2a und 2b ergibt. Sobald der gemeinsame Zielfarbort eingestellt ist, befinden sich die Beleuchtungsvorrichtungen 2 a, b in einem metameren Zustand für das erste Farbmodell.

Allerdings kann dieser gemeinsame Zielfarbort nur in Bezug auf das erste Farbmodell mit der ersten Beobachtergröße eingestellt werden. So wurde nämlich festgestellt, dass sich bei unterschiedlichen Beobachtergrößen das Farbempfinden oder die Farbvalenz ändert. Somit gilt der metamere Zustand nur für die Bedingungen der ersten Beobachtergröße, bei anderen Beobachtergrößen kann sich die Farbähnlichkeit der Beleuchtungsvorrichtungen 2a, b verschlechtern. Eine Änderung der Beobachtergröße in Form der Beobachterfeldgröße kann sich im Betrieb der Beleuchtungsvorrichtungen 2 a, b zum einen durch eine Änderung des Beobachtungsabstands ergeben, wie dies oben in der Figur 1 b dargestellt ist.

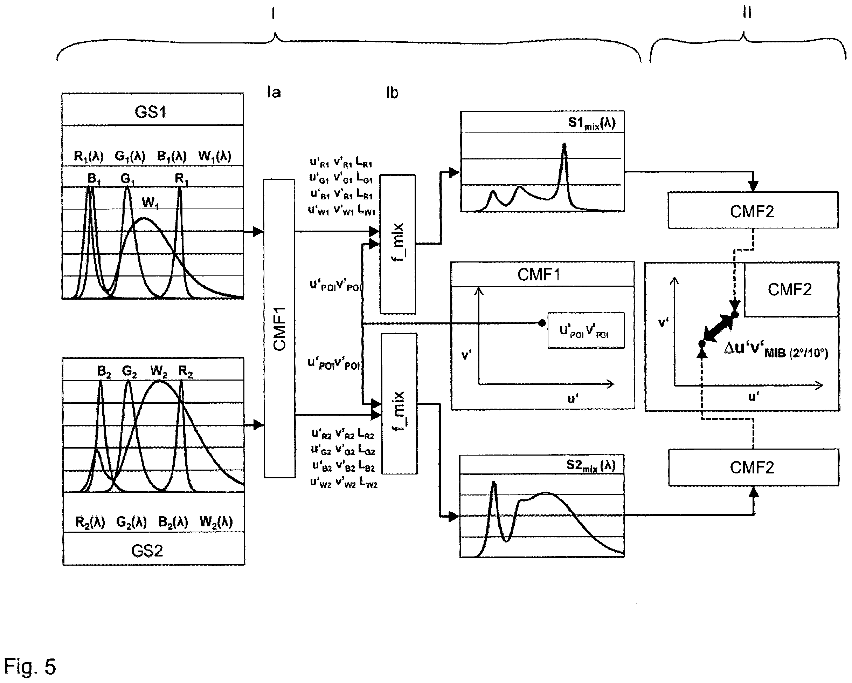

Die Figur 5 zeigt stark schematisiert eine erste Ausführungsform des erfinderischen Verfahrens zur Bestimmung des Metamerie-Indexes (MIB) für die zwei Beleuchtungsvorrichtungen 2a, b. Auf der linken Seite sind wieder die Grundspektren GS1 beziehungsweise GS2 gezeigt.

Ausgehend von den Grundspektren GS1 und GS2 werden in einem ersten Zwischenschritt la über einen ersten Spektralwertfunktionensatz CMF1, welcher für das erste Farbmodell mit der ersten Beobachtergröße, hier der Beobachterfeldgröße BFG1 (zum Beispiel 2 Grad) gültig ist, die Farbkoordinaten u'v' und die maximale Leuchtdichte L der Lichtquellen 1 a, b, c, d bestimmt, sodass sich bei jeder Beleuchtungsvorrichtung 1 a, b für jede Lichtquelle 1 a, b, c, d ein Triple u' v' L wie folgt ergibt:

$$u'_{R1} \; v'_{R1} \; L_{R1}$$

$$u'_{G1} \; v'_{G1} \; L_{G1}$$

$$u'_{B1} \; v'_{B1} \; L_{B1}$$

$$u'_{W1} \; v'_{W1} \; L_{W1}$$

$$u'_{R2} \; v'_{R2} \; L_{R2}$$

$$u'_{G2} \; v'_{G2} \; L_{G2}$$

$$u'_{B2} \; v'_{B2} \; L_{B2}$$

$$u'_{W2} \; v'_{W2} \; L_{W2}$$

Ferner wird ein erster Referenzfarbort (POI, point of interest) $u'_{POI} \; v'_{POI} \; L_{POI}$ definiert, wobei der erste Referenzfarbort die gewünschte Farbe in dem ersten Farbmodell repräsentiert.

In einem zweiten Zwischenschritt Ib werden über einen Mischalgorithmus f_mix für jede der Beleuchtungsvorrichtungen 1 a, b die Verhältnisse ermittelt, in denen die Lichtquellen 1 a, b, c, d angesteuert werden müssen, damit die

resultierenden Mischspektren $S1_{mix}$(Lambda) und $S2_{mix}$(Lambda) denselben ersten Farbort im u' v'-Diagramm in Bezug auf das erste Farbmodell mit der ersten Beobachterfeldgröße BFG 1 besitzen wie der erste Referenzfarbort $u'_{POI}$ $v'_{POI}$ sowie die gewünschte Leuchtdichte. Die Mischspektren $S1_{mix}$(Lambda) und $S2_{mix}$(Lambda) sind in der Figur 5 jeweils über die Wellenlänge Lambda aufgetragen und zeigen die normierten Intensitäten.

In einem zweiten Schritt II werden die Mischspektren $S1_{mix}$(Lambda), $S2_{mix}$(Lambda) mithilfe eines zweiten Spektralwertfunktionensatzes CMF2 bewertet, der auf ein zweites Farbmodell mit der zweiten Beobachtergröße, hier der Beobachterfeldgröße BFG2 abgestimmt ist. Hierbei werden die zweiten Farbörter der Beleuchtungsvorrichtungen 2a und 2b in Bezug auf die zweite Beobachterfeldgröße BFG2 in dem zweiten Farbmodell mit dem zweiten Spektralwertfunktionensatz CMF2 bestimmt und mit u' v' Koordinaten dargestellt.

Der Abstand zwischen den zweiten Farbörtern der Beleuchtungsvorrichtungen 2a, b bildet den Farbortabstand delta u'v'$_{MIB(BFG1/BFG2)}$ und damit den Metamerie-Index (MiB).

Die Berechnung des Metamerie-Index für Beobachterabhängigkeit erfolgt also beispielsweise zusammenfassend wie folgt: Ausgegangen wird von zwei RGBW-LED-Systemen. Zuerst werden für die einzelnen LED-Grundspektren der beiden zu vergleichenden RGBW-Systeme die Farbkoordinaten u'v' mit Hilfe der Zwei-Grad-Spektralwertfunktionen und die maximale Leuchtdichte der Einzelkomponenten ermittelt. Mit Hilfe eines Farbmischalgorithmus werden dann die Verhältnisse ermittelt, in denen die einzelnen LEDs angesteuert werden müssen, damit das Mischspektrum denselben Farbort im u'v' - Diagramm (zwei Grad) besitzt wie der Referenzfarbort und die gewünschte Leuchtdichte besitzt. Die beiden sich ergebenden Mischspektren stellen ein metameres Paar in Bezug auf die Zwei-Grad-Spektralwertfunktionen dar. Berechnet man nun die Farbörter dieser beiden Spektren mit Hilfe der Zehn-Grad-Spektralwertfunktionen, entspricht die resultierende Farbdifferenz zwischen den beiden Spektren dem Metamerie-Index für Beobachterabhängigkeit in Form einer Beobachterfeldgrößenabhängigkeit.

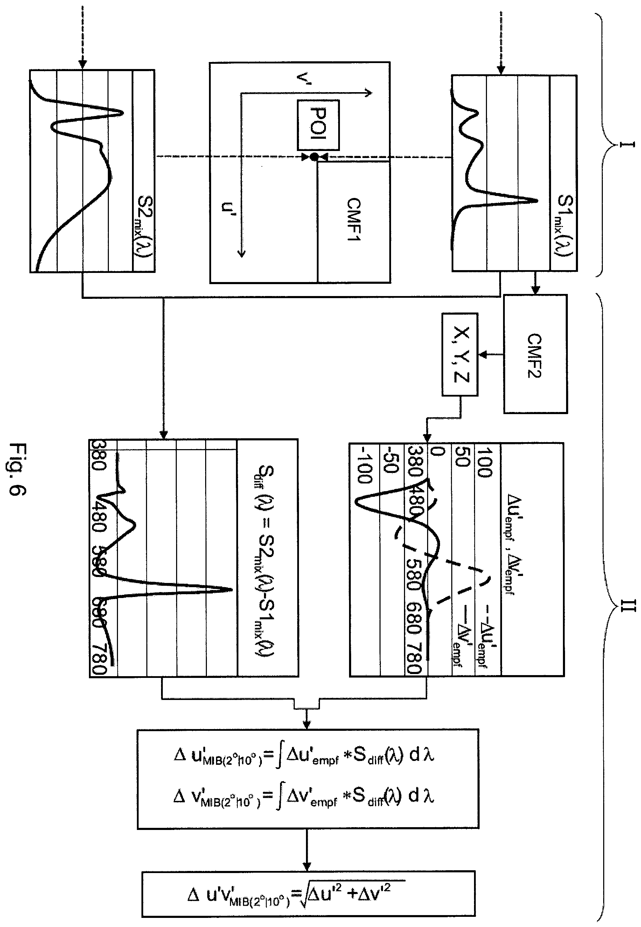

In der Figur 6 ist ein zweites Ausführungsbeispiel der Erfindung visualisiert, wobei das Verfahren im Schritt I in gleicher Weise wie bei dem ersten Ausführungsbeispiel in der Figur 5 umgesetzt wird. Nachfolgend wird aus den beiden Mischspektren ein Differenzspektrum berechnet,

$$S_{diff}(\lambda) = S1_{mix}(\lambda) - S2_{mix}(\lambda)$$

Ferner wird ein Änderungsempfindlichkeitsfunktionensatz für den zweiten Farbort der ersten Beleuchtungsvorrichtung 2a in dem zweiten Farbmodell erstellt. Der Änderungsempfindlichkeitsfunktionensatz ist ein Maß für die Änderung wie die Unterschiede der Mischspektren in dem Differenzspektrum zu dem Metamerie-Index (MiB) beitragen. In einem nächsten Schritt wird mit Hilfe des Änderungsempfindlichkeitsfunktionensatzes und dem Differenzspektrum der Metamerie-Index (MiB) wie vorab bereits erläutert berechnet.

Das Verfahren kann in der vorgeschlagenen Weise zur Bestimmung eines Metamerie-Indexes (MiB) herangezogen werden. Das Verfahren wird mit weiteren Schritten erweitert und daraus wird ein Verfahren zum Sortieren von Lichtquellen bzw. Beleuchtungsvorrichtungen abgeleitet. Hierbei werden ähnlich wie bei dem Binning von LEDs Lichtquellen bzw. Beleuchtungsvorrichtungen in gemeinsame Klassen oder Bins sortiert, deren Metamerie-Index (MIB) in Bezug auf eine Referenzbeleuchtungsvorrichtung sich in dem gleichen Bereich befinden und/oder unter einem definierten Schwellwert liegt. Bei dem Verfahren zum Sortieren wird eine der Beleuchtungsvorrichtungen als die Referenzbeleuchtungsvorrichtung angenommen, so dass diese Beleuchtungsvorrichtung nur einmal vermessen oder berechnet werden muss. Nachfolgend werden weitere Beleuchtungsvorrichtungen als Testbeleuchtungsvorrichtungen gegen die Referenzbeleuchtungsvorrichtung in der Weise getestet, dass der Metamerie-Index (MIB) bestimmt wird, wobei jeder Metamerie-Index (MIB) die Farbnähe der Testbeleuchtungsvorrichtung zu der Referenzbeleuchtungsvorrichtung angibt. Auf Basis der Werte der Metamerie-Indizes (MIB) können die Testbeleuchtungsvorrichtungen in Klassen oder Bins eingeteilt werden.

Der Metamerie-Index für Beobachterabhängigkeit wird also über das Differenzspektrum zusammenfassend wie folgt berechnet. Die beiden Mischspektren stellen ein metameres Paar in Bezug auf die Zwei-Grad-Spektralwertfunktionen dar. Auf Basis der Farbkoordinaten des Mischspektrums S1 im u'v' - Diagramm basierend auf den Zehn-Grad-Spektralwertfunktionen werden die spektralen Änderungsempfindlichkeitsfunktionen ermittelt. Diese Funktionen beschreiben, wie stark sich spektrale Differenzen der beiden zu vergleichenden Spektren in einer u' - oder v' - Verschiebung niederschlagen werden. Um mit Hilfe dieser Änderungsempfindlichkeitsfunktionen den Metamerie-Index für Beobachterfeldgrößenabhängigkeit zu ermitteln, werden die beiden Funktionen jeweils wellenlängenweise mit dem Differenzspektrum multipliziert und das Integral gebildet.

**Bezugszeichenliste**

| | |
|---|---|
| 1 a-d | Lichtquelle |
| 2a,b | Beleuchtungsvorrichtung |
| 50 | Referenzschritt |
| 75 | Zwischenschritt |
| 100 | Schritt |
| 150 | Referenzschritt |
| 175 | Zwischenschritt |
| 200 | Schritt |
| ES1,2 | Emissionsspektrum |
| B | Beobachter |
| BFG1,2 | Beobachterfeldgröße |
| GM | Grundmenge |
| CMF1,2 | Spektralwertfunktionensatz |
| ZK | Zwischenklasse |
| FAM | Feinauswahlmenge |
| FK | Farbklasse |
| GAM | Grobauswahlmenge |
| MiB | Metamerie-Index für Beobachterabhängigkeit |
| Smix | Mischspektrum |
| Sdiff | Differenzspektrum |
| L | Leuchtdichte |
| u'/v' | Farbkoordinaten |
| B1/B2 | Einzelspektrum |
| G1/G2 | Einzelspektrum |
| R1/R2 | Einzelspektrum |
| W1/W2 | Einzelspektrum |
| GS1/GS2 | Grundspektrum |
| f_mix | Mischalgorithmus |

**Patentansprüche**

1. Verfahren zum Sortieren von Lichtquellen (1a-d) in eine Farbklasse (FK),
   **dadurch gekennzeichnet, dass**
   in einem ersten Schritt (100) aus einer Grundmenge (GM) der Lichtquellen (1a-d) eine Grobauswahlmenge (GAM) in eine Zwischenklasse (ZK) sortiert wird, wobei die ersten Farbörter der Lichtquellen (1a-d) der Zwischenklasse (ZK) einen Abstand unterhalb eines vorgebbaren Toleranzwerts zu einem ersten Referenzfarbort aufweisen, wobei der erste Referenzfarbort und die ersten Farbörter in einem ersten Farbmodell mit einem ersten Satz von Spektralwertfunktionen (CMF1) festgelegt sind,
   in einem nachfolgenden zweiten Schritt (200) aus der Grobauswahlmenge (GAM) der Lichtquellen (1a-d) eine Feinauswahlmenge (FAM) in die Farbklasse (FK) sortiert wird, wobei die zweiten Farbörter der Lichtquellen (1a-d) der Farbklasse (FK) einen Abstand unterhalb eines vorgebbaren Toleranzwerts zu einem zweiten Referenzfarbort aufweisen, wobei der zweite Referenzfarbort und die zweiten Farbörter in einem zweiten Farbmodell mit einem zweiten Satz von Spektralwertfunktionen (CMF2) festgelegt sind,
   wobei der erste (CMF1) und der zweite Satz von Spektralwertfunktionen (CMF2) unterschiedlich ausgebildet sind, wobei der erste und der zweite Referenzfarbort ein gemeinsamer Referenzfarbort ist und nur diejenigen Lichtquellen (1a-d) in die selbe Farbklasse (FK) sortiert werden, welche sowohl bei dem ersten Satz von Spektralwertfunktionen (CMF1) als auch bei dem zweiten Satz von Spektralwertfunktionen (CMF2) ausreichend nahe zum gemeinsamen ersten bzw. zweiten Referenzfarbort in Bezug auf deren jeweiliges Farbmodell angeordnet sind, so dass Lichtquellen (1a-d) in die Farbklasse (FK) einsortiert werden, welche hinsichtlich mindestens zweier Sätze von Spektralwertfunktionen (CMF1,2) metamer ausgebildet sind.

2. Verfahren nach Anspruch 1, **dadurch gekennzeichnet, dass** die Lichtquellen (1 a-d) als Leuchtdioden, insbesondere als einfarbige LEDs oder OLEDs ausgebildet sind.

3. Verfahren nach Anspruch 1 oder 2, **dadurch gekennzeichnet, dass** der erste (CMF1) und zweite Satz von Spektralwertfunktionen (CMF2) sich hinsichtlich einer Beobachtergröße, insbesondere einer Beobachterfeldgröße und/oder einem Beobachteralter und/oder einem Beobachtergeschlecht und/oder einer ethnischen Beobachterzugehörigkeit unterscheiden.

**4.** Verfahren nach einem der vorhergehenden Ansprüche, **dadurch gekennzeichnet, dass** das erste und/oder das zweite Farbmodell als ein L u'v'-Farbmodell nach CIE ausgebildet ist.

**5.** Verfahren nach einem der vorhergehenden Ansprüche, **dadurch gekennzeichnet, dass** der erste Referenzfarbort durch eine virtuelle oder reale Referenzlichtquelle definiert ist, wobei insbesondere die Lichtquellen (1a-d) in der Zwischenklasse (ZK) metamer zu der Referenzlichtquelle in dem ersten Farbmodell mit dem ersten Satz von Spektralwertfunktionen (CMF1) ausgebildet sind,
und/oder
der zweite Referenzfarbort durch eine virtuelle oder reale Referenzlichtquelle definiert ist, wobei insbesondere der zweite Bereich durch einen maximal erlaubten Metamerie-Index für Beobachterabhängigkeit (MIB) zwischen der zu testenden Lichtquelle (1 a-d) und der Referenzlichtquelle festgelegt ist.

**6.** Verfahren nach einem der Ansprüche 1 bis 4, **dadurch gekennzeichnet, dass** die Farbörter der Lichtquellen (1a-d) experimentell, insbesondere messtechnisch unterstützt, erfasst werden.

**7.** Verfahren nach Anspruch 5, **dadurch gekennzeichnet, dass** die Farbörter der Lichtquellen (1a-d) und/oder der Metamerie-Index für Beobachterabhängigkeit (MIB) experimentell, insbesondere messtechnisch unterstützt, erfasst werden.

**8.** Verfahren nach einem der Ansprüche 5 bis 7, **dadurch gekennzeichnet, dass** in einem ersten Referenzschritt (50) aus dem Emissionsspektrum der Referenzlichtquelle über den ersten Satz von Spektralwertfunktionen (CMF1) für das erste Farbmodell der erste Referenzfarbort in dem ersten Farbmodell ermittelt wird,
dass in einem ersten Zwischenschritt (75) aus den Emissionsspektren der Lichtquellen (1 a-d) über den ersten Satz von Spektralwertfunktionen (CMF1) für das erste Farbmodell die ersten Farbörter in dem ersten Farbmodell ermittelt werden,
dass in einem zweiten Referenzschritt (150) aus dem Emissionsspektrum der Referenzlichtquelle über den zweiten Spektralwertfunktionensatz (CMF2) für das zweite Farbmodell der zweite Referenzfarbort in dem zweiten Farbmodell ermittelt wird,
dass in einem zweiten Zwischenschritt (175) aus den Emissionsspektren der Lichtquellen (1 a-d) über den zweiten Satz von Spektralwertfunktionen (CMF2) für das zweite Farbmodell die zweiten Farbörter in dem zweiten Farbmodell ermittelt werden, wobei der Abstand zwischen dem zweiten Referenzfarbort und den zweiten Farbörtern der Lichtquellen (1a-d) in dem zweiten Farbmodell für jede Lichtquelle (1a-d) einen Farbortabstand definiert, der den Metamerie-Index für Beobachterabhängigkeit (MIB) bildet.

**9.** Verfahren nach einem der vorhergehenden Ansprüche 5 bis 8, **dadurch gekennzeichnet, dass** ein Differenzspektrum (Sdiff) für die beiden Emissionsspektren (ES1, ES2) von einer der Lichtquellen (1 a-d) und der Referenzlichtquelle ermittelt wird und über einen Änderungsempfindlichkeitsfunktionensatz bewertet wird, wobei der Änderungsempfindlichkeitsfunktionensatz ein Maß definiert, wie die Unterschiede der Emissionsspektren (ES1, ES2) in dem Differenzspektrum (Sdiff) zu dem Metamerie-Index für Beobachterabhängigkeit (MIB) beitragen, wobei ausgehend von dem Änderungsempfindlichkeitsfunktionensatz und dem Differenzspektrum (Sdiff) der Farbort-Abstand im zweiten Farbmodell und damit der Metamerie-Index für Beobachterabhängigkeit (MIB) bestimmt werden.

**10.** Verfahren nach einem der vorhergehenden Ansprüche, **dadurch gekennzeichnet, dass** das Verfahren mindestens einen nachfolgenden weiteren Schritt aufweist, wobei in einem nachfolgenden Schritt aus der Feinauswahlmenge (FAM) der Lichtquellen (1a-d) eine Feinauswahlmenge weiterer Ordnung in eine Farbklasse weiterer Ordnung sortiert wird, wobei die weiteren Farbörter der Lichtquellen (1 a-d) der Farbklasse weiterer Ordnung in einem gemeinsamen weiteren Bereich um einen weiteren Referenzfarbort angeordnet sind, wobei der weitere Referenzfarbort und die weiteren Farbörter in einem weiteren Farbmodell mit einem weiteren Satz von Spektralwertfunktionen festgelegt sind, wobei der erste (CMF1), der zweite (CMF2) und jeder weitere Satz von Spektralwertfunktionen unterschiedlich ausgebildet sind.

**Claims**

**1.** Method for grouping light sources (1a-d) into a colour bin (FK),
**characterized in that**

in a first step (100), from a base set (GM) of the light sources (1a-d), a broad selection set (GAM) is grouped into an intermediate bin (ZK), wherein the first colour points of the light sources (1a-d) of the intermediate bin (ZK) have a distance from a first reference colour point that is below a specifiable tolerance value, wherein the first reference colour point and the first colour points are established in a first colour model with a first set of spectral value functions (CMF1),

in a subsequent second step (200), from the broad selection set (GAM) of the light sources (1a-d), a narrow selection set (FAM) is grouped into the colour bin (FK), wherein the second colour points of the light sources (1a-d) of the colour bin (FK) have a distance from a second reference colour point that is below a specifiable tolerance value, wherein the second reference colour point and the second colour points are established in a second colour model with a second set of spectral value functions (CMF2),

wherein the first set (CMF1) and the second set of spectral value functions (CMF2) have different configurations, wherein the first and the second reference colour point is a common reference colour point, and only those light sources (1a-d) are grouped into the same colour bin (FK) which, both in the case of the first set of spectral value functions (CMF1) and in the case of the second set of spectral value functions (CMF2), are arranged sufficiently close to the common first or second reference colour point with respect to their respective colour model so that those light sources (1a-d) can be grouped into the colour bin (FK) which are metameric with respect to at least two sets of spectral value functions (CMF1,2).

2. Method according to Claim 1, **characterized in that** the light sources (1a-d) are configured in the form of light-emitting diodes, in particular as single-colour LEDs or OLEDs.

3. Method according to Claim 1 or 2, **characterized in that** the first set (CMF1) and the second set of spectral value functions (CMF2) differ with respect to an observer variable, in particular an observer field variable and/or an observer's age and/or an observer's gender and/or an ethnic observer group.

4. Method according to one of the preceding claims, **characterized in that** the first and/or the second colour model are configured in the form of an Lu'v' colour model according to CIE.

5. Method according to one of the preceding claims, **characterized in that** the first reference colour point is defined by way of a virtual or real reference light source, wherein in particular the light sources (1a-d) in the intermediate bin are metameric with respect to the reference light source in the first colour model with the first set of spectral value functions (CMF1),

and/or

the second reference colour point is defined by a virtual or real reference light source, wherein in particular the second region is established by way of a maximum permitted metamerism index for observer dependence (MIB) between the light source (1a-d) to be tested and the reference light source.

6. Method according to one of Claims 1 to 4, **characterized in that** the colour points of the light sources (1a-d) are captured experimentally, in particular with metrological support.

7. Method according to Claim 5, **characterized in that** the colour points of the light sources (1a-d) and/or the metamaterism index for observer dependence (MIB) are captured experimentally, in particular with metrological support.

8. Method according to one of Claims 5 to 7, **characterized in that** in a first reference step (50), the first reference colour point in the first colour model is ascertained from the emission spectrum of the reference light source via the first set of spectral value functions (CMF1) for the first colour model,

**in that** in a second intermediate step (75), the first colour points in the first colour model are ascertained from the emission spectra of the light sources (1a-d) via the first set of spectral value functions (CMF1) for the first colour model,

**in that** in a second reference step (150), the second reference colour point in the second colour model is ascertained from the emission spectrum of the reference light source via the second spectral value function set (CMF2) for the second colour model,

**in that** in a second intermediate step (175), the second colour points in the second colour model are ascertained from the emission spectra of the light sources (1a-d) via the second set of spectral value functions (CMF2) for the second colour model, wherein the distance between the second reference colour point and the second colour points of the light sources (1a-d) in the second colour model for each light source (1a-d) defines a colour point distance which forms the metamerism index for observer dependence (MIB).

9. Method according to one of the preceding Claims 5 to 8, **characterized in that** a difference spectrum (Sdiff) for the two emission spectra (ES1, ES2) from one of the light sources (1a-d) and the reference light source is ascertained and assessed via a change sensitivity function set, wherein the change sensitivity function set defines a measure of how the differences in the emission spectra (ES1, ES2) in the difference spectrum (Sdiff) contribute to the metamaterism index for observer dependence (MIB), wherein, starting from the change sensitivity function sets and the difference spectrum (Sdiff), the colour point distance in the second colour model and thus the metamerism index for observer dependence (MID) are determined.

10. Method according to one of the preceding claims, **characterized in that** the method has at least one subsequent further step, wherein in a subsequent step, from the narrow selection set (FAM) of the light sources (1a-d), a narrow selection set of a further order is grouped into a colour bin of a further order, wherein the further colour points of the light sources (1a-d) of the colour bin of further order are arranged in a common further region around a further reference colour point, wherein the further reference colour point and the further colour points are established in a further colour model with a further set of spectral value functions, wherein the first set (CMF1), the second set (CMF2) and each further set of spectral value functions is of different configuration.

## Revendications

1. Procédé de tri de sources de lumière (1a-d) en une classe de couleur (FK),
   **caractérisé en ce que**
   dans une première étape (100), une quantité sélectionnée grossière (GAM) est triée en une classe intermédiaire (ZK) à partir d'une quantité de base (GM) des sources de lumière (1a-d), les premières localisations chromatiques des sources de lumière (lad) de la classe intermédiaire (ZK) présentant un écart inférieure à une valeur de tolérance pouvant être prédéfinie par rapport à une première localisation chromatique de référence, la première localisation chromatique de référence et les premières localisations chromatiques étant définies dans un premier modèle colorimétrique avec un premier ensemble de fonctions de valeurs spectrales (CMF1),
   dans une deuxième étape (200) suivante, une quantité sélectionnée précise (FAM) est triée en la classe de couleur (FK) à partir de la quantité sélectionnée grossière (GAM) des sources de lumière (1a-d), les deuxièmes localisations chromatiques des sources de lumière (1a-d) de la classe de couleur (FK) présentant un écart inférieure à une valeur de tolérance pouvant être prédéfinie par rapport à une deuxième localisation chromatique de référence, la deuxième localisation chromatique de référence et les deuxièmes localisations chromatiques étant définies dans un deuxième modèle colorimétrique avec un deuxième ensemble de fonctions de valeurs spectrales (CMF2),
   le premier (CMF1) et le deuxième ensemble de fonctions de valeurs spectrales (CMF2) étant de configurations différentes,
   la première et la deuxième localisation chromatique étant une localisation chromatique commune et seules sont triées dans la même classe de couleur (FK) les sources de lumière (1a-d) qui sont disposées suffisamment près de la première ou de la deuxième localisation chromatique commune en référence à leur modèle colorimétrique respectif, et ce aussi bien avec le premier ensemble de fonctions de valeurs spectrales (CMF1) qu'avec le deuxième ensemble de fonctions de valeurs spectrales (CMF2), de sorte que les sources de lumière (1a-d) qui sont triées dans la classe de couleur (FK), du point de vue d'au moins deux ensembles de fonctions de valeurs spectrales (CMF1, 2) sont de configuration métamère.

2. Procédé selon la revendication 1, **caractérisé en ce que** les sources de lumière (1a-d) sont réalisées sous la forme de diodes électroluminescentes, notamment sous forme de LED ou d'OLED monochromes.

3. Procédé selon la revendication 1 ou 2, **caractérisé en ce que** le premier (CMF1) et le deuxième ensemble de fonctions de valeurs spectrales (CMF2) se différencient du point de vue d'une taille d'observateur, notamment d'une taille de champ d'observateur et/ou d'un âge d'observateur et/ou d'un genre d'observateur et/ou d'une appartenance ethnique d'observateur.

4. Procédé selon l'une des revendications précédentes, **caractérisé en ce que** le premier et/ou le deuxième modèle colorimétrique est réalisé sous la forme d'un modèle colorimétrique L u'v' selon CIE.

5. Procédé selon l'une des revendications précédentes, **caractérisé en ce que** la première localisation chromatique de référence est définie par une source de lumière de référence virtuelle ou réelle, les sources de lumière (1a-d) dans la classe intermédiaire (ZK) étant notamment configurées métamères par rapport à la première source de lumière de référence dans le premier modèle colorimétrique avec le premier ensemble de fonctions de valeurs spectrales (CMF1)

et/ou
la deuxième localisation chromatique de référence est définie par une source de lumière de référence virtuelle ou réelle, la deuxième zone étant notamment fixée par un indice de métamérie maximum autorisé pour la dépendance à l'observateur (MIB) entre les sources de lumière (1a-d) à tester et la source de lumière de référence.

6. Procédé selon l'une des revendications 1 à 4, **caractérisé en ce que** les localisations chromatiques des sources de lumière (1a-d) sont détectées de manière expérimentale, notamment avec assistance métrologique.

7. Procédé selon la revendication 5, **caractérisé en ce que** les localisations chromatiques des sources de lumière (1a-d) et/ou l'indice de métamérie pour la dépendance à l'observateur (MIB) sont détectés de manière expérimentale, notamment avec assistance métrologique.

8. Procédé selon l'une des revendications 5 à 7, **caractérisé en ce que** dans une première étape de référence (50), la première localisation chromatique est déterminée dans le premier modèle colorimétrique à partir du spectre d'émission de la source de lumière de référence par le biais du premier ensemble de fonctions de valeurs spectrales (CMF1) pour le premier modèle colorimétrique,
   **en ce que** dans une première étape intermédiaire (75), les premières localisations chromatiques dans le premier modèle colorimétrique sont déterminées à partir des spectres d'émission des sources de lumière (1a-d) par le biais du premier ensemble de fonctions de valeurs spectrales (CMF1) pour le premier modèle colorimétrique,
   **en ce que** dans une deuxième étape de référence (150), la deuxième localisation chromatique est déterminée dans le deuxième modèle colorimétrique à partir du spectre d'émission de la source de lumière de référence par le biais du deuxième ensemble de fonctions de valeurs spectrales (CMF2) pour le deuxième modèle colorimétrique,
   **en ce que** dans une deuxième étape intermédiaire (175), les deuxièmes localisations chromatiques dans le deuxième modèle colorimétrique sont déterminées à partir des spectres d'émission des sources de lumière (1a-d) par le biais du deuxième ensemble de fonctions de valeurs spectrales (CMF2) pour le deuxième modèle colorimétrique, l'écart entre la deuxième localisation chromatique de référence et les deuxièmes localisations chromatiques des sources de lumière (1a-d) dans le deuxième modèle colorimétrique définissant un écart de localisation chromatique pour chaque source de lumière (1a-d), lequel forme un indice de métamérie pour la dépendance à l'observateur (MIB).

9. Procédé selon l'une des revendications 5 à 8, **caractérisé en ce qu'**un spectre différentiel (Sdiff) est déterminé pour les deux spectres d'émission (ES1, ES2) de l'une des sources de lumière (1a-d) et de la source de lumière de référence et évalué par le biais d'un ensemble de fonctions de sensibilité aux modifications, l'ensemble de fonctions de sensibilité aux modifications définissant une mesure de la contribution des différences entre les spectres d'émission (ES1, ES2) dans le spectre différentiel (Sdiff) à l'indice de métamérie pour la dépendance à l'observateur (MIB), l'écart de localisation chromatique dans le deuxième modèle colorimétrique et ainsi l'indice de métamérie pour la dépendance à l'observateur (MIB) étant définis à partir de l'ensemble de fonctions de sensibilité aux modifications et du spectre différentiel (Sdiff).

10. Procédé selon l'une des revendications précédentes, **caractérisé en ce que** le procédé comprend au moins une étape supplémentaire suivante, une quantité sélectionnée précise d'ordre supplémentaire étant triée dans une classe de couleur d'ordre supplémentaire dans une étape suivante à partir de la quantité sélectionnée précise (FAM) des sources de lumière (1a-d), les localisations chromatiques supplémentaires des sources de lumière (1a-d) de la classe de couleur d'ordre supplémentaire étant disposées dans une zone supplémentaire commune autour d'une localisation chromatique de référence supplémentaire, la localisation chromatique de référence supplémentaire et les localisations chromatiques supplémentaires étant fixées dans un modèle colorimétrique supplémentaire avec un ensemble de fonctions de valeurs spectrales supplémentaire, le premier (CMF1), le deuxième (CMF2) et chaque ensemble supplémentaire de fonctions de valeurs spectrales étant configurés différemment.

Fig. 1a

Fig. 1b

Fig. 1c

ES1

ES2

W₁

W₂

BFG1

BFG2

GM

100

GAM

ZK ⟶

200

FAM

FK ⟶

Fig. 2

GM

50

75

100

ZK ⟶

GAM

150

175

200

FK ⟶

FAM

Fig. 3

Fig.4

Fig. 5

Fig. 6

$$S_{diff}(\lambda) = S2_{mix}(\lambda) - S1_{mix}(\lambda)$$

$$\Delta u'_{MIB(2°|10°)} = \int \Delta u'_{empf} * S_{diff}(\lambda)\, d\lambda$$

$$\Delta v'_{MIB(2°|10°)} = \int \Delta v'_{empf} * S_{diff}(\lambda)\, d\lambda$$

$$\Delta u'v'_{MIB(2°|10°)} = \sqrt{\Delta u'^2 + \Delta v'^2}$$

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20140028699 A1
- US 20120224177 A1
- WO 2012119158 A1
- US 20100140633 A1
- WO 2012144337 A1
- WO 2008020913 A2

**In der Beschreibung aufgeführte Nicht-Patentliteratur**

- Recueil des travaux et compte rendu des séances. The National Physical Laboratory Teddington. Cambridge at the University Press, 1931, 19-29
- Farbmessung. Hauptversammlung. CIE Publication, 1963, vol. 11A, 37